# EUROPEAN PATENT SPECIFICATION

(11) **EP 0 727 818 B1**
(45) Date of publication and mention of the grant of the patent: **31.03.2004**
(21) Application number: 95100707.9
(22) Date of filing: 19.01.1995
(51) Int. Cl.: H01L 23/16, H01L 23/373, C04B 35/119

(54) **Zirconia-added alumina substrate with direct bonding of copper**
Aluminiumoxidsubstrat mit hinzugefügtem Zirkonoxid zum direkten Verbinden von Kupfer
Substrat en alumine contenant du zircone pour la liaison directe du cuivre

(43) Date of publication of application: 21.08.1996
(73) Proprietor: FUJI ELECTRIC CO., LTD., Kawasaki-shi Kanagawa 210 (JP); SUMITOMO METAL CERAMICS INC., Yamaguchi (JP)
(72) Inventor: Yosida, Shizuyasu, c/o Fuji Electric Co., Ltd., Kawasaki-shi, Kanagawa 210 (JP); Saito, Shigemasa, c/o Fuji Electric Co., Ltd., Kawasaki-shi, Kanagawa 210 (JP); Yamada, Katumi, c/o Fuji Electric Co., Ltd., Kawasaki-shi, Kanagawa 210 (JP); Matuura, Kazuya, c/o Sumitomo Metal Ceramics Inc., Mine-shi, Yamaguchi (JP); Teramura, Kazuhiko, c/o Sumitomo Metal Ceramics, Mine-shi, Yamaguchi (JP); Nozaki, Toshio, c/o Sumitomo Metal Ceramics Inc., Mine-shi, Yamaguchi (JP)
(74) Representative: Grünecker, Kinkeldey, Stockmair & Schwanhäusser Anwaltssozietät

(56) References cited:
- WO-A-88/03917
- DE-C- 3 728 096
- US-A- 4 497 875
- DATABASE WPI Week 9515 Derwent Publications Ltd., London, GB; AN 95-112177 & JP-A-07 038 014 (FUJI ELECTRIC CO LTD) , 7 February 1995
- PATENT ABSTRACTS OF JAPAN vol. 012 no. 221 (E-625) ,23 June 1988 & JP-A-63 015430 (FUJI ELECTRIC CO LTD) 22 January 1988,
- PATENT ABSTRACTS OF JAPAN vol. 015 no. 157 (E-1058) ,19 April 1991 & JP-A-03 029349 (MITSUBISHI ELECTRIC CORP) 7 February 1991,
- PATENT ABSTRACTS OF JAPAN vol. 014 no. 397 (C-0752) ,28 August 1990 & JP-A-02 149464 (ASAHI GLASS CO LTD) 8 June 1990,

## Description

### BACKGROUND OF THE INVENTION

The present invention relates to a substrate for a semiconductor device such as a power transistor module and, more specifically, to a DBOC (direct bonding of copper) substrate in which a copper plate is directly bonded to a ceramic substrate. The above DBOC substrate is described in U.S. Patent No. 3,994,430, for instance.

From US 4,316,964 it is known that ZnO₂ additions to alumina provide improved strength of the resulting ceramic.

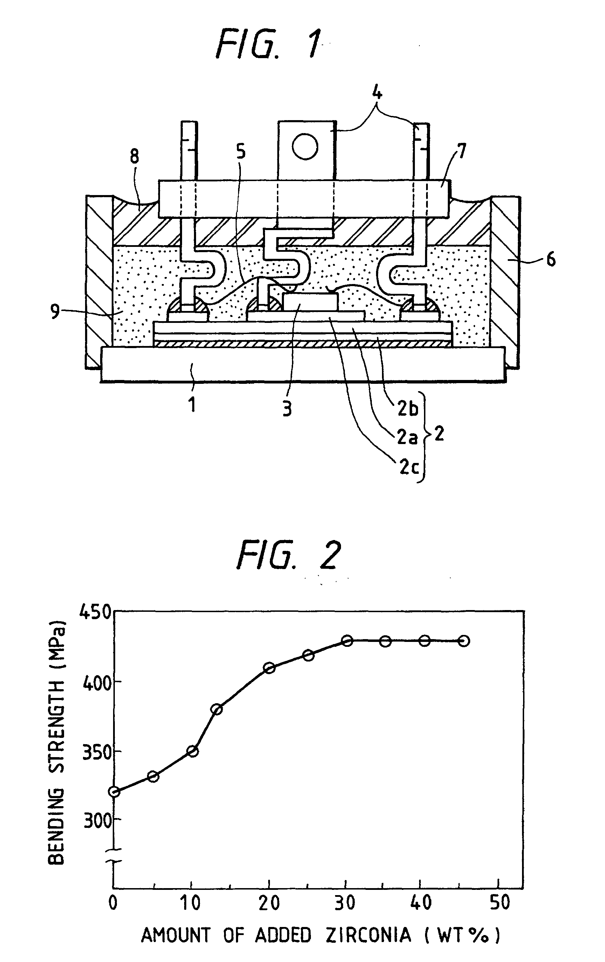

Fig. 1 shows a structure of a semiconductor device assembly that employs a DBOC substrate as mentioned above. In Fig. 1, reference numeral 1 denotes a radiation metal base; 2, a DBOC substrate in which copper plates 2b and 2c are bonded to the back and front faces of a ceramic substrate 2a; 3, a semiconductor chip; 4, lead-out terminals; 5, bonding wires; 6, a resin case; 7, a terminal block; 8, a sealing resin; and 9, a gel-like filler.

In the DBOC substrate 2, thin copper plates 2b and 2c are directly bonded to both faces of the ceramic substrate 2a made of alumina, aluminum nitride, or the like by a direct bond copper method (bonding is effected using, as a bonding agent, a Cu-O eutectic liquid phase that is formed by a reaction between copper and alumina in an inert gas atmosphere with a very small amount of oxygen during heating at 1,065-1,085°C). After the copper plate 2c on the fundamental face side is formed into a circuit pattern, the semiconductor chip 3 is diebonded to the copper plate 2c and bonding of the wires 5 is performed to complete a circuit. Then, the DBOC substrate 2 is soldered onto the radiation metal base 1, and the lead-out terminals 4 are soldered onto the DBOC substrate 2. After the resin case 6 is pasted to the radiation metal base 1 and charged with the gel-like filler 9, sealing performed with the resin 8.

When it is intended to use the DBOC substrate as a substrate of a power semiconductor device such as a power transistor module, one will encounter the following problems.

For example, in the semiconductor device (such as a power transistor) of Fig. 1, a large amount of heat that is generated in the semiconductor chip 3 during a current-conducting operation is conducted to the metal base 1 via the DBOC substrate 2, and radiated outward from the metal base 1. As is understood from the above, the heat conductivity of the DBOC substrate 2 is an important factor of determining the current capacity of the semiconductor device.

By the way, the heat conductivity of the DBOC substrate 2 is relatively low, because the ceramic substrate 2a is used as an insulating base material. Heat conductivities of alumina and aluminum nitride, which are conventionally used as a material of the ceramic substrate 2a, are compared as follows:

| | |
|---|---|
| alumina | 21 W/m•K |
| aluminum nitride | 180 W/m•K |

Although aluminum nitride is much superior to alumina in the heat conductivity, the material cost of the former is higher than that of the latter.

To improve the radiation performance, the present inventors have tried to reduce the resistance of heat conduction of the ceramic substrate 2a made of alumina, whose material cost is low, by making it as thin as possible. However, it has been found that if the thickness of the alumina substrate 2a is reduced to, for instance, about 0.3 mm, its actual strength is lowered. As a result, when the semiconductor chip (silicon) 3 is bonded to the copper plate 2c, thermal stress due to a difference between thermal expansion coefficients of materials of the above members causes many crack defects in the substrate 2a, resulting in an insulation failure of the substrate 2a. Thermal expansion coefficients of the respective materials are listed below:

| | |
|---|---|
| silicon (semiconductor chip) | 4.0 x 10⁻⁶/°C |
| alumina | 7.5 x 10⁻⁶/°C |
| copper | 18.0 x 10⁻⁶/°C |

### SUMMARY OF THE INVENTION

The present invention has been made in view of the above problems, and has an object of providing a ceramic substrate for a semiconductor device which substrate is mainly made of alumina (whose material cost is low) and can be made thinner and improved in radiation performance, by increasing the mechanical strength, particularly the bending strength, of the substrate material by improving the material composition. scrate material by improving the material composition.

The above object is attained by a substrate, according to claim 1.

The mechanical strength, particularly the bending strength, of the ceramic substrate that is, as described above, a fired body and has a material composition in which alumina is the main component and zirconia is added to it, is greatly increased from a ceramic substrate using only alumina. Further, by adding zirconia in a range of 10-30 wt%, the mechanical strength, particularly the flexibility, is improved without lowering the heat conductivity of the ceramic substrate. This allows the substrate itself to be made thinner, to thereby realize a DBOC substrate having superior radiation performance as a substrate for a semiconductor device.

By adding, in addition to zirconia, one of yttria, calcia, magnesia and ceria at a ratio of 0.5-2 wt%, the toughness of zirconia crystal grains can be improved while the ceramic substrate firing temperature is kept low. Instead of adding yttria, calcia, magnesia or ceria separately from zirconia, zirconia that is stabilized totally or partially by such an additive may be added to alumina, in which case similar advantages can also be obtained.

### BRIEF DESCRIPTION OF THE DRAWINGS

Fig. 1 is a sectional view of a semiconductor device assembly that employs a DBOC substrate;
Fig. 2 is a graph showing a relationship between the amount of zirconia added to alumina and the bending strength of a substrate; and
Fig. 3 is a graph showing a relationship between the amount of zirconia added to alumina and the heat conductivity of a substrate.

### DESCRIPTION OF THE PREFERRED EMBODIMENT

An embodiment of the present invention will be hereinafter described.

First, zirconia were added to alumina, and the resulting material was pulverized and mixed into particles of 0.5-3 µm in diameter. The resulting mixture was added with 8-wt% polyvinyl butyral (PVB) as a binder, a 50-wt% mixed liquid of toluene and xylene as a solvent, and 2-wt% dioctyl phthalate (DOP) as a plasticizer, kneaded for about 20 hours, and then shaped into a sheet form by a doctor blade method, to thereby provide a green sheet. The green sheet was pressed, i.e., punched to produce substrate pieces of a predetermined shape, which were then fired at 1,550-1,650°C. Thus, ceramic substrates of 0.32 mm in thickness were formed.

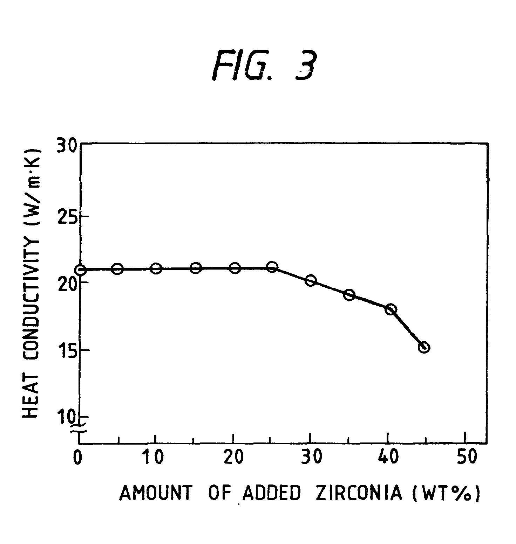

To evaluate mechanical properties of the ceramic substrate that was formed in the above manner by adding zirconia to alumina, another samples were prepared in the same manner while the amount of added zirconia was varied from 0 to 45 wt% and subjected to a strength test. Results of the strength test is shown in Fig. 2. As seen from Fig. 2, by adding zirconia to alumina by more than 10 wt%, the strength of the ceramic substrate is improved to 350-400 MPa from the case of using only alumina (amount of added zirconia: 0 wt%; strength: about 300 MPa). It is noted that the strength is not improved any further even if the amount of added zirconia is increased exceeding 30 wt%.

On the other hand, the heat conductivity of the above samples was also examined, to produce results shown in Fig. 3. That is, the samples exhibit approximately the same heat conductivity as the case of using only alumina as long as the amount of added zirconia is less than about 30 wt%. The heat conductivity decreases as the amount of added zirconia exceeds 30 wt%.

It is therefore concluded that by selecting the material composition of the ceramic substrate such that contents of alumina and zirconia are 70-90 wt% and 10-30 wt%, respectively, the mechanical strength of the ceramic substrate can be improved from the case of using only alumina while the equivalent heat conductivity is maintained.

Further, ceramic substrate samples (thickness: 0.32 mm; width: 35 mm) in which the amount of added zirconia was 10 wt% and samples of the same size which used only alumina were subjected to a bending test in which the distance between supporting points was 40 mm. The samples using only alumina exhibited a maximum bending length of 0.30 mm. In contrast, it has been confirmed that the samples containing zirconia endure up to a bending length of 0.45 mm.

In the above-described material composition, yttria may be added to alumina and zirconia to assist sintering of alumina and zirconia and to improve the toughness of zirconia crystal grains. It is preferred that yttria be added in a range of 0.5-2 wt%. If the amount of added yttria is smaller than 0.5 wt%, the substrate firing temperature exceeds 1,650°C, to make it difficult to manufacture substrates. On other hand, if it exceeds 2 wt%, large variations likely occur in the contraction ratio and the strength of the ceramic substrate. It has been confirmed that similar advantages are obtained by adding, separately from zirconia, one of calcia, magnesia, ceria, etc. instead of yttria. It has also been confirmed that similar advantages are obtained by adding, to alumina, zirconia that is stabilized totally or partially by yttria, calcia, magnesia, ceria, or the like.

A semiconductor device as shown in Fig. 1 was assembled by using a DBOC substrate that was formed by directly bonding 0.3-mm-thick tough pitch electrolytic copper plates to the front and back faces of the above-described zirconia-added alumina substrate (thickness: 0.32 mm) by placing the copper plates on the alumina substrate and heating that structure for 10 minutes in a nitrogen atmosphere at 1,050-1,075°C. As comparative examples, similar semiconductor devices were assembled by using DBOC substrates of 0.63 and 0.32 mm that were formed by using only alumina. The above assemblies were subjected to a mechanical deformation resistance test and an intermittent circuit test.

In the deformation resistance test, while the ceramic substrate was given a forcible deformation by applying an external force to the radiation metal base, its deformation amount was checked until an insulation failure occurs in it. It has been found that the zirconia-added alumina substrate (thickness: 0.32 mm) and the 0.63-mm-thick alumina substrate exhibit almost the same resistance, whereas an insulation failure occurs in the alumina substrate of 0.32-mm-thick alumina substrate with approximately a half deformation amount. That is, in a practical sense, the thickness of the ceramic substrate can be reduced to about 1/2 by adding a proper amount of zirconia to alumina.

In the intermittent circuit test, it has been found that with the same collector loss, the temperature increase ΔTj of the semiconductor bonding block of the zirconia-added alumina substrate (thickness: 0.32 mm) is reduced by about 20% from that of the 0.63-mm-thick alumina substrate and the intermittent current conduction resistance of the former is improved to 2.5-3 times that of the latter.

As is understood from the above tests, the ceramic substrate in which zirconia is added to alumina is superior in mechanical strength to the ceramic substrate using only alumina. Because the ceramic substrate can be made thinner, it is fully expected to be used as a substrate for a semiconductor device which substrate has superior radiation performance.

In the above embodiment, the ceramic substrate has a thickness of 0.32 mm. Substrates of 0.05-1 mm in thickness can be produced by the sheet forming method. On the other hand, substrates having a thickness of more than 1 mm can be produced by a press molding method in which a binding agent such as polyvinyl alcohol (PVA) is added to material powders, they are subjected to wet blending, and then a mixture as dried and granulated by a spray dryer is subjected to press molding.

As described above, according to the invention, by using, as a ceramic substrate for a DBOC substrate, ceramics produced by adding zirconia to alumina and firing the resulting mixture at a high temperature, the mechanical strength can be greatly increased from the conventional ceramic substrate using only alumina. As a result, in practical applications, the ceramic substrate can be made thinner, to thereby realize a DBOC substrate having superior radiation performance as a substrate for a semiconductor device. In particular, when applied to a substrate for a power transistor module, for instance, the invention can greatly contribute to miniaturization of a semiconductor device and increase of the current capacity.

Similar advantages can be obtained when the ceramic substrate of the invention is applied to an IC package, a printed circuit board of, for instance, a hybrid IC, and like purposes, because the substrate itself has superior mechanical properties.

## Claims

1. A substrate for a semiconductor device, comprising a ceramic substrate consisting of 70-90 wt% alumina and 10-30 wt% zirconia, wherein said zirconia is partially stabilised by dispersing at least one of yttria, calcia, magnesia and ceria; and further comprising a copper plate directly bonded to the ceramic substrate, wherein said substrate has a thickness of from 0.05 to 0.32 mm.

2. A substrate for a semiconductor device, according to claim 1, wherein said zirconia is totally stabilised.

## Patentansprüche

1. Substrat für eine Halbleitervorrichtung mit einem keramischen Substrat, das 70 - 90 Gew.-% Aluminiumoxid und 10 - 30 Gew.-% Zirkonoxid umfasst, wobei das Zirkonoxid teilweise durch Dispergieren mindestens entweder von Yttriumoxid, Kalziumoxid, Magnesiumoxid oder Ceroxid stabilisiert ist, und weiterhin aufweisend eine Kupferplatte, direkt an dem keramischen Substrat angebondet, wobei das Substrat eine Dicke von 0,05 bis 0,32 mm besitzt.

2. Substrat für eine Halbleitervorrichtung nach Anspruch 1, wobei das Zirkonoxid vollständig stabilisiert ist.

## Revendications

1. Substrat pour dispositif à semiconducteur, comprenant un substrat de céramique qui est constitué de 70 à 90 %, en poids, d'alumine et de 10 à 30 %, en poids, de zircone, où ladite zircone est partiellement stabilisée par dispersion d'au moins un des éléments suivants, à savoir yttria, calcia, magnésie et oxyde cérique ; et comprenant en outre une plaque de cuivre directement liée au substrat de céramique, où ledit substrat possède une épaisseur de 0,05 à 0,32 mm.

2. Substrat pour dispositif à semiconducteur selon la revendication 1, où ladite zircone est totalement stabilisée.
